# EUROPEAN PATENT APPLICATION

(11) **EP 3 432 015 A1**
(43) Date of publication of application: **23.01.2019**
(21) Application number: 16894352.0
(22) Date of filing: 15.03.2016
(51) Int. Cl.: G01R 31/36, G01R 19/165, H01M 10/42

(54) **STORAGE CELL MANAGEMENT DEVICE AND STORAGE CELL MANAGEMENT METHOD**

(71) Applicant: Kabushiki Kaisha Toshiba, Minato-ku Tokyo 105-0023 (JP); Toshiba Infrastructure Systems & Solutions Corporation, Kawasaki-shi, Kanagawa, Tokyo 212-0013 (JP)
(72) Inventor: KANEKO, Norihiro, Tokyo 105-8001 (JP); OKABE, Ryo, Tokyo 105-8001 (JP); KIKUCHI, Yusuke, Tokyo 105-8001 (JP); ONODA, Takayuki, Tokyo 105-8001 (JP); KURODA, Kazuto, Tokyo 105-8001 (JP); SEKINO, Masahiro, Tokyo 105-8001 (JP); TAKAHASHI, Jun, Tokyo 105-8001 (JP)
(74) Representative: AWA Sweden AB
(86) International application number: PCT/JP2016/058172
(87) International publication number: WO 2017/158730

(57) **Abstract**

A storage battery management device according to an embodiment includes a connector, storage, a drive voltage controller, a determiner, and a current sensor controller. The connector is connectable to a current sensor. The storage stores current sensor information including an output range of normal output values and each current-sensor type indicating a type of a current sensor connectable to the connector in association with each other. The drive voltage controller causes a current to flow through a current sensor while varying a voltage to be applied to the current sensor. The determiner determines, based on whether an output value that is received via the connector from the current sensor driven by the current caused by the drive voltage controller falls in the output range corresponding to the current-sensor type, the current-sensor type of the current sensor connected to the connector. The current sensor controller controls the current sensor in accordance with the determined current-sensor type.

## Description

### FIELD

Embodiments of the present invention relate to a storage battery management device and a storage battery management method.

### BACKGROUND

Being one element of a storage battery system, various types of current sensors differing in drive voltage and communication method are available. Conventionally, analog current sensors have been widely used in storage battery systems in social infrastructure. In recent years, however, use of controller area network (CAN) current sensors has become popular.

### CITATION LIST

### Patent Literature

Patent Literature 1: Japanese Patent Application Laid-open Publication No. 2007-298414
Patent Literature 2: Japanese Patent Application Laid-open Publication No. 2009-192295
Patent Literature 3: Japanese Patent Application Laid-open Publication No. 2014-081691

### SUMMARY OF THE INVENTION

### Problem to be Solved by the Invention

It is, however, difficult for a conventional storage battery management device to efficiently determine a type of current sensor used in the storage battery system to control the current sensor with an appropriate drive voltage in accordance with the type. Thus, such a conventional storage battery management device is connectable to a certain type of current sensors alone. It is therefore difficult to use the same storage battery management device for current sensors of different types including analog and CAN.

### Means for Solving Problem

A storage battery management device according to an embodiment includes a connector, storage, a drive voltage controller, a determiner, and a current sensor controller. The connector is connectable to a current sensor. The storage stores current sensor information including an output range and each current-sensor type in association with each other, the output range being a range of normal output values, the current-sensor type indicating a type of each current sensor connectable to the connector. The drive voltage controller causes a current to flow through the current sensor while varying a voltage to be applied to the current sensor. The determiner determines, based on whether an output value that is received via the connector from the current sensor driven by the current caused by the drive voltage controller falls in the output range corresponding to the current-sensor type. The current sensor controller controls the current sensor in accordance with the determined current-sensor type.

### BRIEF DESCRIPTION OF DRAWINGS

FIG. 1 is a block diagram illustrating one example of a schematic configuration of a storage battery system according to a first embodiment.
FIG. 2 is a diagram illustrating one example of a hardware configuration of a BMU in the first embodiment.
FIG. 3 is an explanatory diagram for explaining the connection between the BMU and an analog current sensor in the first embodiment.
FIG. 4 is an explanatory diagram for explaining the connection between the BMU and a CAN current sensor in the first embodiment.
FIG. 5 is a functional block diagram of the BMU in the first embodiment.
FIG. 6 is a diagram illustrating one example of a configuration of a current-sensor information table in the first embodiment.
FIG. 7 is a flowchart illustrating one example of a current-sensor type determination procedure in the first embodiment.
FIG. 8 is a diagram illustrating another example of the current-sensor information table in the first embodiment.
FIG. 9 is a functional block diagram of a BMU according to a second embodiment.
FIG. 10 is a diagram illustrating one example of a voltage-value list for determination in the second embodiment.
FIG. 11 is a flowchart illustrating one example of a current-sensor type determination procedure in the second embodiment.
FIG. 12 is a functional block diagram of a BMU according to a third embodiment.
FIG. 13 is a diagram illustrating one example of initial and maximum drive-voltage value information in the third embodiment.
FIG. 14 is a flowchart illustrating one example of a current-sensor type determination procedure in the third embodiment.
FIG. 15 is a flowchart illustrating one example of a current-sensor type determination procedure according to a modification.

### DETAILED DESCRIPTION

### First Embodiment

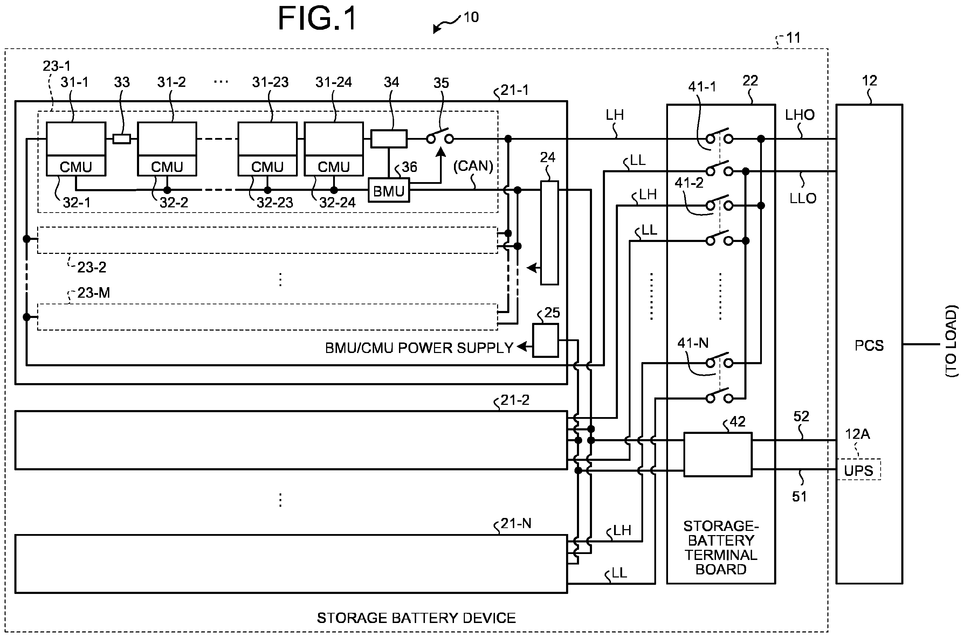

FIG. 1 is a schematic block diagram illustrating a configuration of a storage battery system including a storage battery device according to a first embodiment. A storage battery system 10, as illustrated in FIG. 1, includes a storage battery device 11 that stores electric power, and a power conditioning system (PCS) 12 that converts DC power supplied from the storage battery device 11 into AC power having desired power quality and supplies it to a load.

The storage battery device 11 includes a plurality of battery boards 21-1 to 21-N (N is a natural number) and a battery terminal board 22 to which the battery boards 21-1 to 21-N are connected.

The battery boards 21-1 to 21-N include a plurality of battery units 23-1 to 23-M (M is a natural number) connected in parallel with each other, a gateway device 24, and a DC power supply device 25 that supplies DC power to a battery management unit (BMU) 36 and cell monitoring units (CMU) 32-1 to 32-24 for operation, which will be described later.

The configuration of the battery units 23-1 to 23-M will be described. The battery units 23-1 to 23-M are each connected to output power lines (bus bars) LHO and LLO via a high-potential power supply line LH and a low-potential power supply line LL, to supply electric power to the power conditioning system device 12 that is a main circuit.

The battery units 23-1 to 23-M have the same configuration, therefore, the battery unit 23-1 will be described as an example. The battery unit 23-1 includes a plurality of (24 in FIG. 1) cell modules 31-1 to 31-24, a plurality of (24 in FIG. 1) CMUs 32-1 to 32-24 mounted on the respective cell modules 31-1 to 31-24, a service disconnect 33 provided between the cell module 31-1 and the cell module 31-2, a current sensor 34, and a contactor 35. The cell modules 31-1 to 31-24, the service disconnect 33, the current sensor 34, and the contactor 35 are connected in series.

The cell modules 31-1 to 31-24 constitute a battery pack in which battery cells are connected in series and in parallel. The cell modules 31-1 to 31-24 connected in series form a battery pack group.

The battery unit 23-1 further includes the BMU 36. The communication lines of the respective CMUs 32-1 to 32-24 and the output line of the current sensor 34 are connected to the BMU 36.

The current sensor 34 is connected in series to the high potential side of the cell modules 31-1 to 31-24. The current sensor 34 detects the amount and direction of current flowing through the cell modules 31-1 to 31-24, and transmits results of the detection to the BMU 36.

The BMU 36 controls, under the control of the gateway device 24, the entire battery unit 23-1, and controls opening and closing of the contactor 35 based on results of communication with the CMUs 32-1 to 32-24 (voltage data and temperature data which will be described later) and a detection result of the current sensor 34.

Next, the configuration of the storage-battery terminal board 22 will be described. The storage-battery terminal board 22 includes a plurality of board breakers 41-1 to 41-N corresponding to the battery boards 21-1 to 21-N, and a master device 42 being a microcomputer to control the entire storage battery device 11.

The master device 42 and the power conditioning system 12 are connected via a control power supply line 51 and a control communication line 52. The control power supply line 51 is for supplying power to the master device 42 via an uninterruptible power system (UPS) 12A of the power conditioning system 12. The control communication line 52 is configured as Ethernet (registered trademark), through which control data are transferred between the master device 42 and the power conditioning system 12.

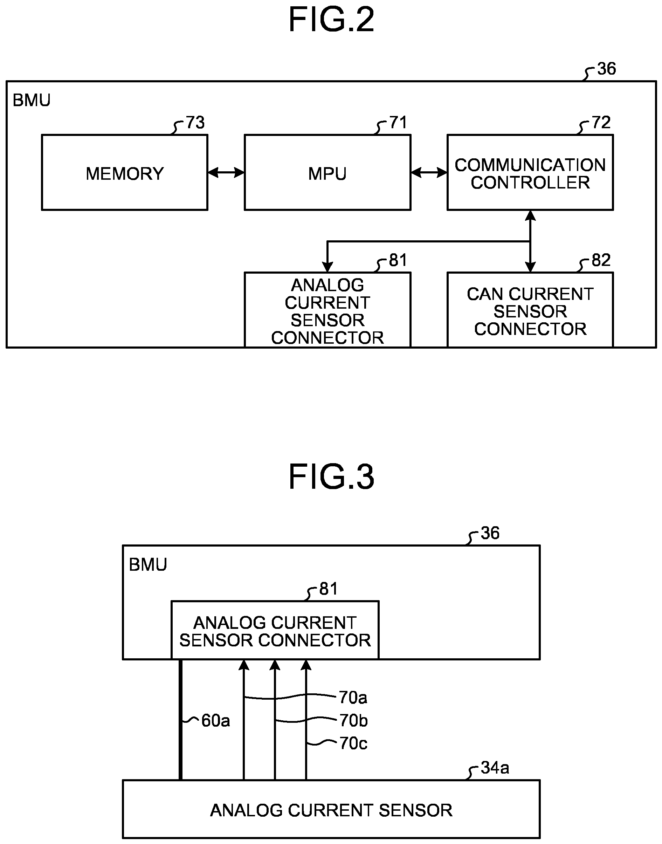

Next, the communication between the current sensor 34 and the BMU 36 will be described in detail. FIG. 2 is a diagram illustrating a hardware configuration of the BMU.

The BMU 36, as illustrated in FIG. 2, includes a micro processing unit (MPU) 71, a communication controller 72, and a memory 73. The BMU 36 further includes at least an analog current sensor connector 81 and a CAN current sensor connector 82 as connectors to the current sensor 34. In the first embodiment, the connector of the BMU 36 is not limited to the analog current sensor connector 81 and the CAN current sensor connector 82. Any connector is adoptable as long as it is connectable to a current sensor that can be controlled by the BMU 36.

The MPU 71 controls the entire BMU 36.

The communication controller 72 controls signal communication between the current sensor 34 and the CMUs 32-1 to 32-24.

The memory 73 is one example of storage in the first embodiment, and stores current sensor information 100 which will be described later. The memory 73 further receives and stores results of current detection from the current sensor 34.

In the first embodiment, although the memory 73 is a non-volatile writable memory, it is not limited to a particular storage medium. Alternatively, data may be temporarily stored in a volatile memory and, at the end of process or upon stop of the BMU 36, the data may be transferred to a non-volatile storage medium. An external device, not depicted, may write data into the memory 73.

The analog current sensor connector 81 is a connector that is connectable to an analog current sensor 34a illustrated in FIG. 3 which will be described later. The analog current sensor 34a notifies the analog current sensor connector 81 of a result of detected current amount as a voltage value.

The MPU 71 converts the notified voltage value into a current value to know the amount of current flowing through the cell modules 31-1 to 31-24.

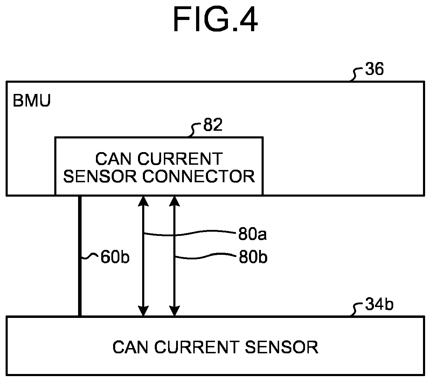

The CAN current sensor connector 82 is a connector that is connectable to a CAN current sensor 34b illustrated in FIG. 4 which will be described later. The CAN current sensor connector 82 communicates with the CAN current sensor 34b in conformity with the CAN standard. The CAN current sensor 34b is the current sensor 34 that performs communication in conformity with the CAN standard.

In the first embodiment, each of the battery units 23-1 to 23-M includes one current sensor 34. Thus, the BMUs 36 are connected to either the analog current sensors 34a or the CAN current sensors 34b.

In the first embodiment the analog and the CAN are examples of the type of the current sensor 34. The BMU 36 may include a connector that is connectable to the current sensor 34 of another type in addition to them.

A single battery system 10 typically uses the current sensors 34 of the same type in all the battery units 23-1 to 23-M. The first embodiment, however, is not particularly limited to use of the current sensors 34 of the same type in the entire storage battery system 10.

FIG. 3 is a diagram illustrating the BMU 36 connected to the analog current sensor 34a.

As illustrated in FIG. 3, the BMU 36 and the analog current sensor 34a are connected via a power-supply drive line 60a and signal lines 70a to 70c.

The signal lines 70a to 70c are a low-range line 70a, a high-range line 70b, and a ground (GND) line 70c, and are connected to the analog current sensor connector 81 of the BMU 36.

The power-supply drive line 60a is a power supply line for driving the analog current sensor 34a.

The low-range line 70a and the high-range line 70b are signal lines for transmitting an output value from the analog current sensor 34a to the analog current sensor connector 81.

The low-range line 70a is capable of transmitting the current amount of 30A or less. Thus, the MPU 71 receives a result of transmission of the current amount of 30 A or less through the low-range line 70a. The MPU 71 further receives a result of transmission of the current amount exceeding 30 A via the high-range line 70b.

The power-supply drive line 60a and the signal lines 70a to 70c illustrated in FIG. 3 may be integrated as a single cable. In this case, the analog current sensor 34a and the analog current sensor connector 81 can be connected via a single cable alone, making it possible to prevent an operator from erroneously connecting the lines.

Next, FIG. 4 is a diagram illustrating the BMU 36 connected to the CAN current sensor 34b.

As illustrated in FIG. 4, the CAN current sensor connector 82 of the BMU 36 and the CAN current sensor 34b are connected via a power-supply drive line 60b and two signal lines 80a and 80b.

The CAN current sensor 34b notifies the CAN current sensor connector 82 of a result of detection of the current amount via the signal lines 80a and 80b.

The power-supply drive line 60b is a power supply line for driving the CAN current sensor 34b. The power-supply drive line 60a illustrated in FIG. 3 and the power-supply drive line 60b illustrated in FIG. 4 are branched from a single power-supply drive line 60 inside the BMU 36. That is, in the BMU 36 of the first embodiment, the analog current sensor 34a and the CAN current sensor 34b use the power supplied via the same power-supply drive line 60.

The power-supply drive line 60b and the signal lines 80a and 80b illustrated in FIG. 4 may be integrated as a single cable.

The BMU 36 is connected to the analog current sensor 34a and the CAN current sensor 34b via the same power-supply drive line 60, which can prevent a human error such as erroneous wiring.

However, the analog current sensor 34a and the CAN current sensor 34b differ in drive voltage, which will be described later. Because of this, the BMU 36 needs to vary the voltage to be applied to the connected current sensor 34 depending on the type of the current sensor 34.

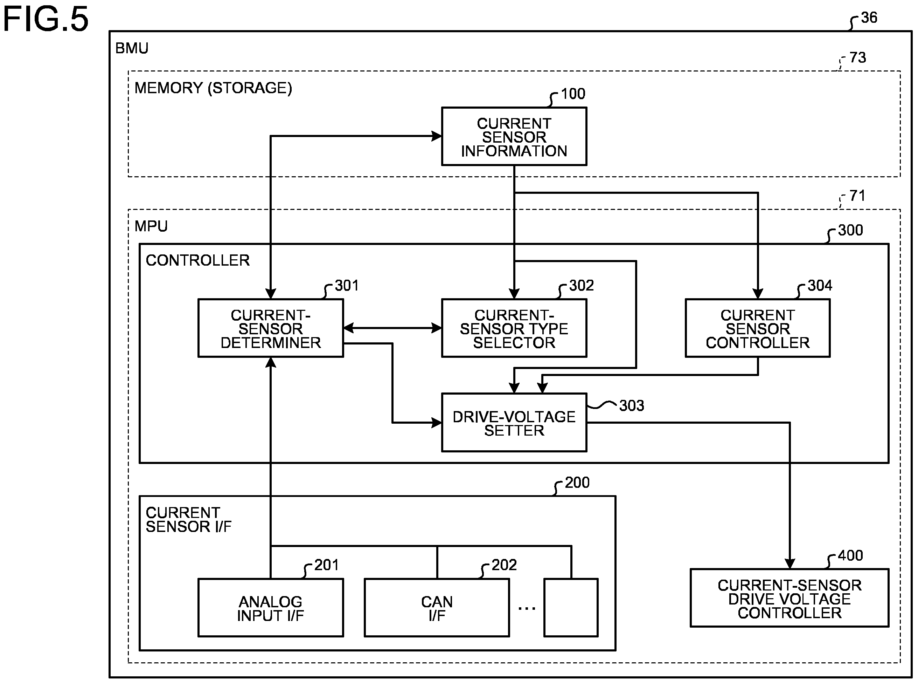

Hence, the BMU 36 in the first embodiment has a function of varying the voltage to be applied to the connected current sensor 34 and efficiently determining the type of the current sensor 34 in accordance with the signal received from the current sensor 34 concerned. The BMU 36 thus uses the same power-supply drive line 60 in common for the current sensors 34 irrespective of different optimal voltages of the current sensors 34 of different types. The function of the BMU 36 that determines the type of the current sensors 34 and allows a current to flow therethrough by applying an appropriate drive voltage will be described in detail with reference to FIGS. 5 to 7.

The configurations of the connectors between the BMU 36 and the current sensors 34 in the first embodiment are merely exemplary and are not limited thereto. For example, the configuration of the current sensor 34 may be different depending on the product specifications of the current sensor 34 in use.

Next, the functional configuration of the BMU 36 of the first embodiment will be described. FIG. 5 is a block diagram illustrating in detail the functional configuration of the MPU 71 and the memory 73 inside the BMU 36 illustrated in FIG. 2.

The current sensor information 100 is, as in the foregoing, stored in the memory 73. The current sensor information 100 is data containing registered attribute information of each type of the current sensors 34 that are connectable to the analog current sensor connector 81 or the CAN current sensor connector 82 of the BMU 36 of the first embodiment. The attribute information of each type of the current sensor 34 indicates the attribute of each current sensor 34, and in the first embodiment, corresponds to the drive voltage and the output range of each current sensor 34. The current sensor information 100 also contains registered information on results of determination by a later-described current-sensor determiner 301 in association with the types.

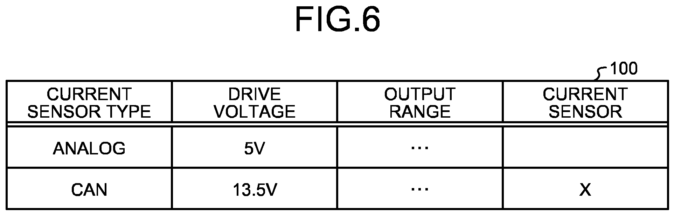

FIG. 6 is an explanatory diagram illustrating one example of the current sensor information 100 used in the first embodiment. In the current sensor information 100 of the first embodiment, as illustrated in FIG. 6, current-sensor type and items of the attribute information, i.e., drive voltage, output range, and current sensor are registered in association with one another.

The type of the current sensor 34 connectable to the BMU 36 of the first embodiment is referred to as current-sensor type.

In the first embodiment the current-sensor types in the current sensor information 100 include at least analog and CAN. In FIG. 6, the current-sensor type "analog" indicates analog type and "CAN" indicates CAN type.

The drive voltage represents a voltage value at which the current sensor 34 can be driven and normally operate by a flow of current therethrough.

The value of drive voltage differs among different types of current sensors. The drive voltage value of a typical analog current sensor 34a is, for example, 5 V. The drive voltage value of a typical CAN current sensor 34b is 13.5 V higher than the drive voltage of the analog current sensor 34a.

However, the drive voltage values differ depending on individual product specifications. The drive voltage value of the analog current sensor 34a can be from 4.75 V to 5.25 V. The drive voltage value of the CAN current sensor 34b can be from 8 V to 16 V depending on the product.

The drive voltages in the current sensor information 100 are sorted in ascending order and the current sensor information 100 stores the attribute information of each current-sensor type.

The output range represents a range of normal output values of the current sensor 34. When the output value of the current sensor 34 falls in the output range, the current sensor 34 is determined to be driven and operating normally.

The output range differs depending on the type of the current sensor 34. For example, the output values of the normally driven analog current sensor 34a of the first embodiment is 0 to 5 V, therefore, the output range is output thresholds of 0 to 5 V. The values are stored in the record item "output range" of the analog current-sensor type in the current sensor information 100.

Meanwhile, the output values of the normally driven CAN current sensor 34b are signals in conformity with the CAN standard, thus, the output range represents signal values in conformity with the CAN standard. The values are stored in the record item "output range" of the CAN current-sensor type in the current sensor information 100".

The item "current sensor" in the current sensor information 100 stores results of determination on the current-sensor type of the current sensor 34 connected to the BMU 36. Specifically, a flag can be set in the item "current sensor". A set flag signifies that the current-sensor type of a record with the set flag is determined to be connected to the BMU 36.

For example, FIG. 6 shows an input flag "X" in the record item "current sensor" of the current sensor "CAN". This indicates a determination result that the CAN current sensor 34b is connected to the BMU 36.

Referring back to FIG. 5, the MPU 71 functions, by executing a program stored in the memory 73, as a current sensor interface (I/F) 200, a controller 300, and a current-sensor drive voltage controller 400.

The current sensor I/F 200 receives an output value from the current sensor 34 via the current sensor connectors 81 and 82. The current sensor I/F 200 then sends the received output value of the current sensor 34 to the current-sensor determiner 301.

To deal with different input values from the different current-sensor types, the current sensor I/F 200 of the first embodiment includes an analog input I/F 201 and a CAN I/F 202.

The analog input I/F 201 receives an output value of the analog current sensor 34a via the analog current sensor connector 81. The CAN I/F 202 receives an output value from the CAN current sensor 34b via the CAN current sensor connector 82.

The current sensor I/F 200 may further include an I/F capable of receiving a signal from the current sensor 34 of another type.

The controller 300 includes the current-sensor determiner 301, a current-sensor type selector 302, a drive-voltage setter 303, and a current-sensor controller 304.

The current-sensor type selector 302 selects one of the current sensor types registered in the current sensor information 100. The current-sensor type selector 302 selects the current-sensor types in order from the one registered in a first record in the current sensor information 100.

The drive-voltage setter 303 selects one of the registered drive voltages of the respective current-sensor types in order from the one registered in the first record in the current sensor information 100. The drive-voltage setter 303 transmits the selected drive voltage to the current-sensor drive voltage controller 400, which will be described later.

As in the foregoing, the current sensor information 100 stores the attribute information of each current sensor-type in ascending order of the drive voltage. That is, the drive-voltage setter 303 selects the registered drive voltages in the current sensor information 100 in order from a minimum value.

The current-sensor drive voltage controller 400 controls the voltage at which the current flows through the power-supply drive line 60 that connects between the BMU 36 and the current sensor 34. The current-sensor drive voltage controller 400 applies a voltage to the current sensor 34 to cause a current to flow therethrough so as to be able to drive the current sensor 34.

In the first embodiment, upon initial activation of the BMU 36, the current-sensor drive voltage controller 400 allows a current to flow through the current sensor 34 while varying an applied voltage, in order to identify the type of the current sensor 34 connected to the BMU 36. In the first embodiment, the current-sensor drive voltage controller 400 applies the drive voltage selected by the drive-voltage setter 303 to the current sensor 34 to cause a current to flow through the current sensor 34. That is, the current-sensor drive voltage controller 400 applies to the current sensor 34 the registered drive voltages in the current sensor information 100 in order from the minimum value, to allow a current to flow through the current sensor 34.

The current-sensor determiner 301 determines, based on the current sensor information 100, the current-sensor type of the current sensor 34 connected to the current sensor connectors 81 and 82 of the BMU 36, and stores the result thereof in the current sensor information 100 in the memory 73.

Specifically, the current-sensor determiner 301 determines whether the output value of the current sensor 34, as driven by the current flow by the current-sensor drive voltage controller 400, falls in the output range of the current-sensor type, selected by the current-sensor type selector 302, in the current sensor information 100. When the output value of the current sensor 34 falls in the output range, the current-sensor determiner 301 determines that the current-sensor type selected by the current-sensor type selector 302 is the current-sensor type of the current sensor 34 connected to the analog current sensor connector 81 or the CAN current sensor connector 82 of the BMU 36.

Ae exemplary determination-result storing method is that the current-sensor determiner 301 sets a flag to the item "current sensor" of the record, which stores the current-sensor type matching the type of the current sensor 34 connected to the BMU 36, in the current sensor information 100.

In the first embodiment, although the current-sensor determiner 301 is configured to store results of the determination on the current-sensor type in the current sensor information 100, the location of storage is not limited thereto. For example, the current-sensor determiner 301 may store the determination results in an area of the memory 73 other than the current sensor information 100, or may store them in an external storage device communicable with the MPU 71.

If the BMU 36 is activated while no determination is made on the type of the current sensor 34 connected to the BMU 36, the current-sensor determiner 301 determines the current-sensor type, as described above.

That is, basically, upon initial activation of the BMU 36, the current-sensor determiner 301 determines the current-sensor type of the current sensor 34 connected to the current sensor connectors 81 and 82, and stores the result thereof in the current sensor information 100. At second and subsequent activations of the BMU 36, the current sensor information 100 contains the determination results of the current-sensor types, therefore, the current-sensor determiner 301 does not make the determination.

When determining non-normal connection between the current sensor 34 and the BMU 36, the current-sensor determiner 301 transmits a signal to a display (not depicted) to display a notice of non-normal connection. The storage battery system 10 may include the display, or an external device connected via a network communicable with the storage battery system 10 may include the display.

The term "non-normal" includes the situations that the current sensor 34 is not connected to the current sensor connectors 81 and 82, that the current sensor I/F 200 is connected thereto but not receiving a normal output value due to erroneous connection of the signal lines 70a to 70c or of the signal lines 80a and 80b, and that the current sensor 34 is faulty.

When the current-sensor determiner 301 has not determined the current-sensor type of the current sensor 34 connected to the BMU 36, the current-sensor type selector 302 and the drive-voltage setter 303 repeat the selection as described above until the current-sensor determiner 301 determines the current-sensor type or detects anomaly.

The current-sensor controller 304 controls the current sensor 34 in accordance with the current-sensor type determined by the current-sensor determiner 301. The control of the current sensor 34 by the current-sensor controller 304 includes allowing a flow of current through the current sensor 34 to drive the current sensor 34, and stopping the current flow to halt the current sensor 34, for example.

Referring to the current sensor information 100, the current-sensor controller 304 determines that the current-sensor type has been determined, when the flag is set to the item "current sensor" in any one of the records.

At the time of driving the current sensor 34 when a stored determination result is available, the current-sensor controller 304 notifies the drive-voltage setter 303 of the drive voltage of the current-sensor type in question to select.

The drive-voltage setter 303, upon receiving the notification from the current-sensor controller 304, selects the drive voltage value of the current-sensor type corresponding to the stored determination result, and transmits the value to the current-sensor drive voltage controller 400.

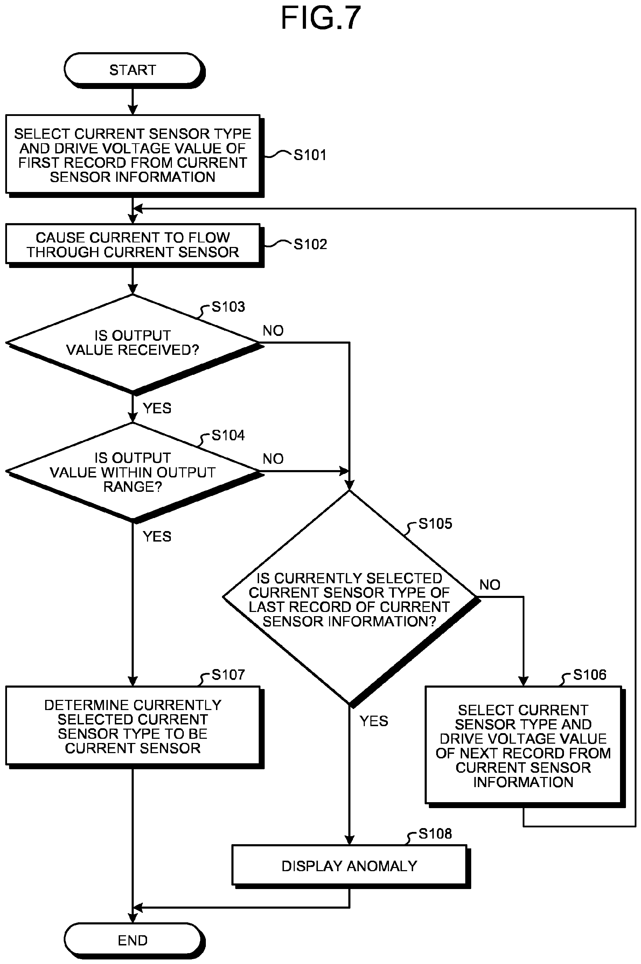

Next, the current-sensor type determination process by the above-configured BMU 36 of the first embodiment will be described. FIG. 7 is a flowchart illustrating a current-sensor type determination procedure of the first embodiment.

At start of the process of the flowchart, for example, the current-sensor determiner 301 detects no stored results of determination on the current-sensor type in the memory 73 upon initial activation of the BMU 36.

At first Step S101, the current-sensor type selector 302 selects the current-sensor type of a first record from the current sensor information 100. The drive-voltage setter 303 selects the drive voltage of the first record from the current sensor information 100.

At next Step S102, the current-sensor drive voltage controller 400 applies the drive voltage selected by the drive-voltage setter 303 to the current sensor 34, causing a current to flow through the current sensor 34.

At Step S103, the current-sensor determiner 301 determines whether the current sensor I/F 200 has received an output value from the current sensor 34.

Upon determining receipt of the output value (Yes at S103), at Step S104 the current-sensor determiner 301 determines, referring to the current sensor information 100, whether the output value of the current sensor 34 received by the current sensor I/F 200 is within the output range of the current-sensor type selected by the current-sensor type selector 302.

When the current sensor I/F 200 have received no output value from the current sensor 34 (No at S103) or when the received output value does not fall in the output range (No at S104), the current-sensor determiner 301 proceeds to the operation at Step S105.

At Step S105, the current-sensor determiner 301 determines, referring to the current sensor information 100, whether the current-sensor type currently selected by the current-sensor type selector 302 is of the last record in the current sensor information 100.

When the current-sensor type is not of the last record (No at S105), at Step S106 the current-sensor type selector 302 selects the current-sensor type of a next record from the current sensor information 100. The drive-voltage setter 303 selects the drive voltage of the next record from the current sensor information 100.

Returning to Step S102, the current-sensor drive voltage controller 400 applies the drive voltage selected by the drive-voltage setter 303 to the current sensor 34 to cause a current to flow through the current sensor 34.

Subsequently, at Step S103, the current-sensor determiner 301 determines whether the current sensor I/F 200 has received an output value from the current sensor 34.

When the current sensor I/F 200 has received no output value from the current sensor 34 (No at S103) or when the received output value does not fall in the output range (No at S104), the current-sensor determiner 301 repeats the operation from Step S102 to Step S106 until the current-sensor type of the last record in the current sensor information 100 (No at S105).

When the current sensor I/F 200 receives an output value from any of the current-sensor types that falls in the output range (Yes at S104), the current-sensor determiner 301 proceeds to Step S107.

At Step S107, the current-sensor determiner 301 determines that the current-sensor type currently selected by the current-sensor type selector 302 is the current-sensor type of the current sensor 34 connected to the BMU 36, and registers the determined current-sensor type in the current sensor information 100. This completes the determination process.

Meanwhile, upon determining receipt of no normal output values from all the current-sensor types registered in the current sensor information 100, the current-sensor determiner 301 proceeds to Step S108 after making determination on the last record (Yes at S105).

At Step S108, the current-sensor determiner 301 transmits a signal to the display (not depicted) to display a notice of non-normal connection. In this case, the determination process is ended.

When the determination process ends due to non-normal connection, the current-sensor determiner 301 does not store the result of the determination in the current sensor information 100. Thus, upon next activation of the BMU 36, the current-sensor determiner 301 starts the determination process from Step S101 again.

Using the data in FIG. 6 as an example, the flow of the above process will be described in detail. First, the current-sensor type selector 302 selects the current-sensor type "analog" from the first record of the current sensor information 100. The drive-voltage setter 303 selects "5 V" as drive voltage from the first record in the current sensor information 100 (S101).

The current-sensor drive voltage controller 400 applies a drive voltage of 5 V to the current sensor 34 to cause a current to flow (S102), and the current sensor I/F 200 does not receive an output value (No at S103).

The selected current-sensor type "analog" is not of the last record in the current sensor information 100 (No at S105). Thus, the current-sensor type selector 302 selects the current-sensor type "CAN" from the current sensor information 100 (S106). The drive-voltage setter 303 selects "13.5 V" as drive voltage (S106).

Returning to Step S102, the current-sensor drive voltage controller 400 applies a drive voltage of 13.5 V selected by the drive-voltage setter 303 to the current sensor 34 to cause a current to flow through the current sensor 34.

Upon determining receipt of an output value (Yes at S103) fallings within the output range of the current sensor-type "CAN" (Yes at S104), the current-sensor determiner 301 can determine the connection of the CAN current sensor 34b to the BMU 36 and normal operation of the CAN current sensor 34b.

Lastly, the current-sensor determiner 301 inputs the flag "X" to the record item "current sensor" of the current-sensor type "CAN", completing the determination process (S107).

As in the foregoing, according to the first embodiment, the current-sensor determiner 301 of the BMU 36 can identify the type of the current sensor 34 that is driven by the current flow by the current-sensor drive voltage controller 400 to output the output value, by comparing the output range associated with the current-sensor type selected by the current-sensor type selector 302 from the current sensor information 100 and the output value in question. Thus, according to the first embodiment, it is possible to automatically determine the current-sensor type of the current sensor 34 from the output value of the current sensor 34, enabling efficient current-sensor type determination.

Moreover, in the first embodiment, the current sensor I/F 200 of the BMU 36 can receive the output values from the current sensors 34 of different current-sensor types via the current sensor connectors 81 and 82, and the current-sensor controller 304 controls the current sensors 34 in accordance with the current-sensor type determined by the current-sensor determiner 301. Thus, according to the first embodiment, a worker installing the BMU 36 can connect the current sensor 34 to the BMU 36 to run the storage battery system 10 without considering parameter settings for the current-sensor type. Consequently, according to the first embodiment, preparation and man-hours for the installation work of the BMU 36 can be cut down. Furthermore, according to the first embodiment, it is easy to change the type of the current sensor 34, which enables the operator of the storage battery system 10 to freely select or change the current sensor 34 depending on their convenience or demand.

In addition, the BMU 36 of the first embodiment can be used in common for the storage battery systems 10 including different types of the current sensors 34, ensuring compatibility with the existing BMU 36.

According to the first embodiment, the current-sensor drive voltage controller 400 applies to the current sensor 34 the voltage at which the current sensor 34 is drivable to cause a current to flow, thereby eliminating the necessity for preparing multiple power-supply drive lines 60 for the current sensors 34 in accordance with the drive voltage of each current-sensor type. Thus, according to the first embodiment, only the single power-supply drive line 60 is needed, preventing erroneous wiring of the power-supply drive lines 60.

In the BMU 36 of the first embodiment, upon activation of the BMU 36 while no determination is made on the current-sensor type, the current-sensor determiner 301 determines the current-sensor type and stores the determined current-sensor type in the memory 73. Then, the current-sensor controller 304 controls the current sensor 34 in accordance with the current-sensor type stored in the memory 73.

Thus, according to the first embodiment, it is possible to determine the current sensor type without fail at the time of initial activation of the BMU 36, to control the current sensor 34 in accordance with the result of the determination. Thus, according to the first embodiment, it is possible to prevent the storage battery system 10 from being operated without the current sensor-type determined. The BMU 36 of the first embodiment hence contributes to avoiding the occurrence of failures attributable to the current sensor 34 at the startup of the storage battery system 10, which can reduce total man-hours for the installation of a battery system.

In the case of reactivation of the BMU 36 after the current-sensor type determination, previously determined current-sensor types are stored in the memory 73. This eliminates the necessity for determining the current-sensor type upon every activation of the BMU 36 according to the first embodiment.

Moreover, according to the BMU 36 of the first embodiment, in the current sensor information 100, one or two or more drive voltages of the current sensors 34 are registered in association with the respective current-sensor types. The BMU 36 includes the drive-voltage setter 303 that selects the one or two or more drive voltages registered in the current sensor information 100 in order from the minimum value. The current-sensor drive voltage controller 400 applies the drive voltage selected by the drive-voltage setter 303 to the current sensor 34, causing a current to flow therethrough.

That is, the BMU 36 of the first embodiment can efficiently determine the current-sensor type at a smaller number of times using the drive voltage registered in the current sensor information 100. According to the first embodiment, the current sensor 34 connected to the BMU 36 can be prevented from being damaged by a current flow with an applied voltage exceeding the drive voltage of the current sensor 34.

Moreover, according to the BMU 36 of the first embodiment, the current-sensor types registered in the current sensor information 100 include analog and CAN. The BMU 36 can thus handle major current sensors 34 used in the storage battery system 10.

The format of the current sensor information 100 is not limited to the one in FIG. 6. As in the foregoing, the current sensors 34 of the same type as analog or CAN differ in the drive voltage depending on the individual product specifications. When the BMU 36 is connectable to current sensors 34 having different drive voltages, the current sensor information 100 may contain separate records for different products having different drive voltages for information management.

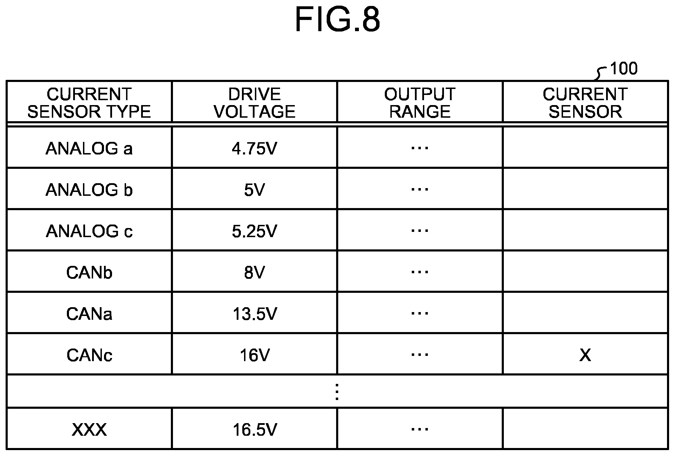

FIG. 8 illustrates a modification of the current sensor information 100. In the example of FIG. 8, in the current sensor information 100, one or two or more drive voltages of the current sensors 34 are registered in association with each current-sensor type. In this example, CAN c, being an exemplary product of the CAN current sensor 34b, is connected to the BMU 36. The drive voltage of the CAN c is 16 V that is higher than that of a typical CAN current sensor 34. Separately registering the records as above makes it possible for the drive-voltage setter 303 to select an appropriate drive voltage value.

The analog and CAN in the first embodiment are exemplary types of the current sensors 34. The BMU 36 may be configured to be connectable to other types of the current sensors 34. In this case, the current sensor information 100 additionally stores records of a new current-sensor type.

In the first embodiment as in the foregoing, the current-sensor determiner 301 stores results of the determination on the current-sensor type by setting the flag to the item of the current sensor information 100. However, the method and location of the storage of the determination results are not limited thereto. The current sensor information 100 may store additional data other than the foregoing items.

### Second Embodiment

In the first embodiment, the drive-voltage setter 303 selects a drive voltage from the current sensor information 100 for applying the drive voltage to the current sensor 34 by the current-sensor drive voltage controller 400, causing a current to flow. In a second embodiment, however, a drive-voltage setter 1303 selects a drive voltage value from a voltage-value list 101 in the memory 73.

The configuration of the storage battery system 10 and the configurations of the current sensor connectors 81 and 82 for connecting the BMU 36 and the current sensor 34 in the second embodiment are the same as those in the first embodiment described with reference to FIGS. 1 to 4.

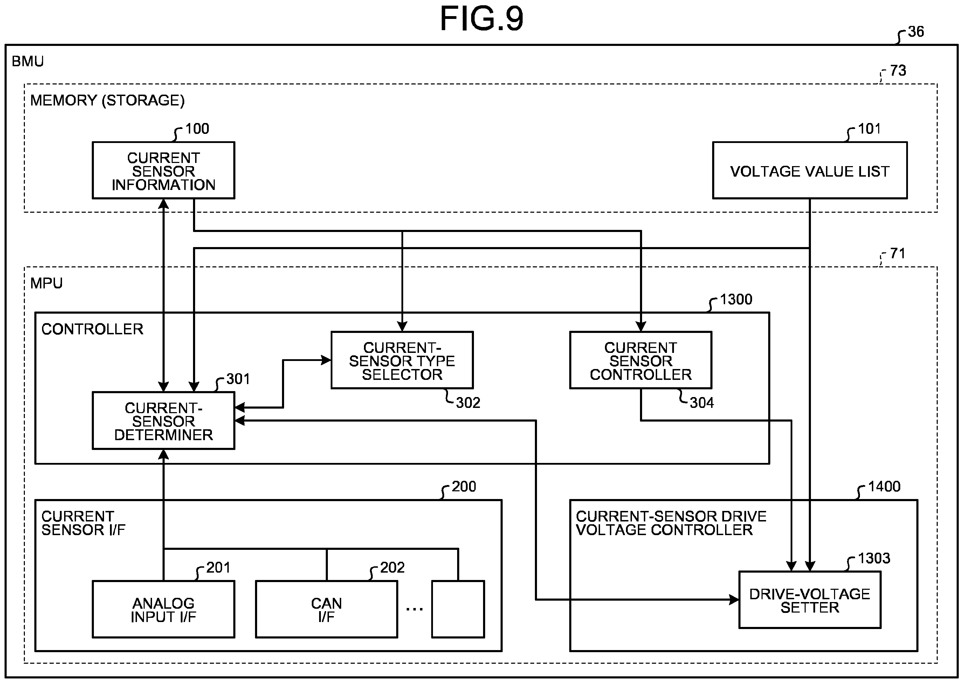

The functional configuration of the MPU 71 and the memory 73 inside the BMU 36 in the second embodiment will be described. FIG. 9 is a block diagram illustrating in detail one example of the functional configuration of the MPU 71 and the memory 73 inside the BMU 36 of the second embodiment.

The memory 73 of the second embodiment is a storage medium that stores the voltage-value list 101 in addition to the current sensor information 100.

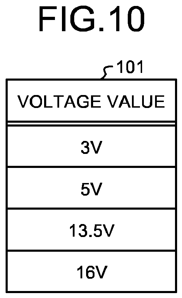

The voltage-value list 101 is a list of one or two or more preset drive voltage values. FIG. 10 is a diagram illustrating one example of the voltage-value list 101 in the second embodiment. The voltage-value list 101, as illustrated in FIG. 10, stores candidate values of the drive voltage to be applied to the current sensor 34, sorted in order from a minimum value.

The location of storage of the voltage-value list 101 is not limited to the memory 73, and the voltage-value list 101 may be set as fixed values to a current-sensor drive voltage controller 1400, for example.

The current sensor information 100 of the second embodiment holds no drive voltage information. As for the other items, the current sensor information 100 holds data similar to that in the first embodiment described with reference to FIG. 6.

Referring back to FIG. 9, the current-sensor drive voltage controller 1400 of the second embodiment includes the drive-voltage setter 1303. Thus, a controller 1300 includes no drive-voltage setter 303. The rest of the configuration of the BMU 36 is the same as that in the first embodiment described with reference to FIG. 5.

The drive-voltage setter 1303 of the second embodiment selects drive voltage values from the voltage-value list 101 in order from a minimum value. To drive the current sensor 34, the current-sensor drive voltage controller 1400 applies a selected drive voltage to the current sensor 34 to cause a current to flow through the current sensor 34.

That is, in the second embodiment, the drive-voltage setter 1303 selects the drive voltage value not from the current sensor information 100 but from the voltage-value list 101.

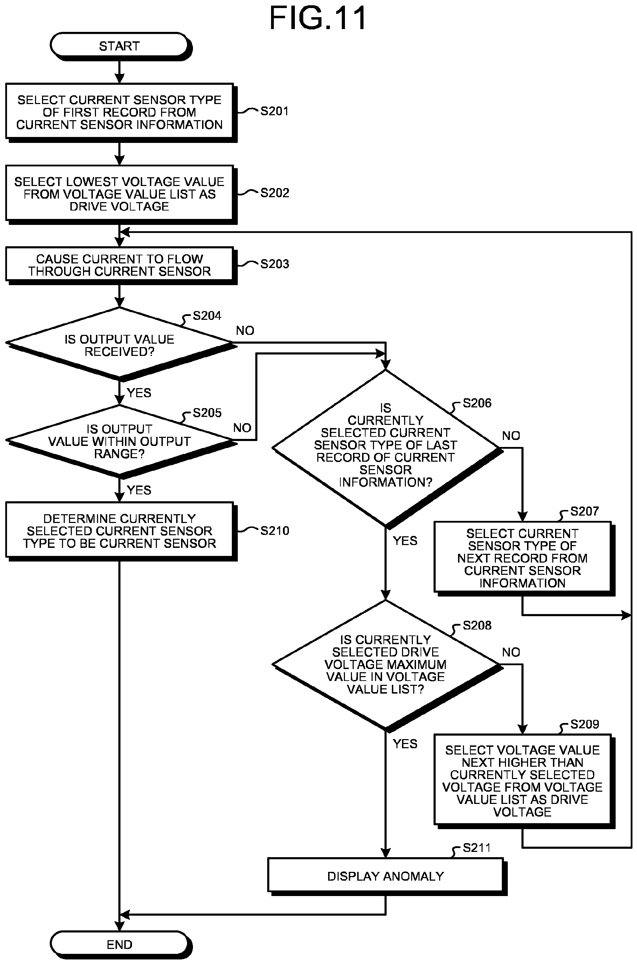

Next, the current-sensor type determination process by the above-configured BMU 36 of the second embodiment will be described. FIG. 11 is a flowchart illustrating a current-sensor type determination procedure of the second embodiment. As with the first embodiment, at start of the process of the flowchart, for example, the current-sensor determiner 301 detects no stored result of determination on the current-sensor type in the memory 73, upon initial activation of the BMU 36.

At Step S201, the current-sensor type selector 302 selects the current-sensor type of a first record from the current sensor information 100.

At Step S202, the drive-voltage setter 1303 selects a lowest voltage value from the voltage-value list 101 as the drive voltage.

At Step S203, the current-sensor drive voltage controller 1400 applies the drive voltage selected by the drive-voltage setter 1303 to the current sensor 34, causing a current to flow therethrough.

At Step S204, the current-sensor determiner 301 determines whether the current sensor I/F 200 has received an output value from the current sensor 34.

Upon determining receipt of the output value at Step S204 (Yes at S204), at Step S205 the current-sensor determiner 301 determines, referring to the current sensor information 100, whether the output value of the current sensor 34 received by the current sensor I/F 200 is within the output range of the current-sensor type selected by the current-sensor type selector 302.

When the current sensor I/F 200 has received no output value from the current sensor 34 (No at S204) or when the received output value does not fall in the output range (No at S205), the current-sensor determiner 301 proceeds to the operation at Step S206.

At Step S206, the current-sensor determiner 301 determines, referring to the current sensor information 100, whether the current-sensor type currently selected by the current-sensor type selector 302 is of the last record in the current sensor information 100.

When it is not of the last record (No at S206), at Step S207 the current-sensor type selector 302 selects the current-sensor type of a next record from the current sensor information 100.

Then, returning to Step S203, the current-sensor drive voltage controller 1400 applies to the current sensor 34 the same drive voltage as the previous one to cause a current to flow therethrough.

When the current sensor I/F 200 does not receive an output value of the current sensor 34 (No at S204) or when the received output value does not fall in the output range (No at S205), the current-sensor determiner 301 repeats the operation from Step S203 to Step S207 until the current-sensor type of the last record in the current sensor information 100 (No at S206).

Upon determining no receipt of normal output values from all the current-sensor types registered in the current sensor information 100, the current-sensor determiner 301 proceeds to Step S208 after making the determination on the last record (Yes at S206).

At Step S208, the current-sensor determiner 301 determines whether the drive voltage currently selected by the drive-voltage setter 1303 matches the maximum value in the voltage-value list 101.

When the currently selected drive voltage does not match a maximum value in the voltage-value list 101 (No at S208), at Step S209 the drive-voltage setter 1303 selects a voltage next higher than the currently selected voltage from the voltage-value list 101 as the drive voltage. The current-sensor type selector 302 also selects the current-sensor type of the first record from the current sensor information 100.

Returning to Step S203, the current-sensor drive voltage controller 1400 applies the drive voltage selected by the drive-voltage setter 1303 to the current sensor 34 to cause a current to flow therethrough.

When the current sensor I/F 200 receives no output value from the current sensor 34 (No at S204) or when the received output value does not fall in the output range (No at S205), the current-sensor determiner 301 repeats the operation from Step S203 to Step S209 until the maximum value of the drive voltage in the voltage-value list 101 (No at S208).

When an output value within the output range is received with any of the combinations of the drive voltages and the current-sensor types (Yes at S205), at Step S210 the current-sensor determiner 301 determines that the current-sensor type currently selected by the current-sensor type selector 302 is the current-sensor type of the current sensor 34 connected to the BMU 36, and registers the determined current sensor-type in the current sensor information 100. This ends the determination process.

Upon no receipt of an output value within the output range (Yes at S208) through the repeated operation from Step S203 to Step S209 to all the current-sensor types with all the drive voltages including the maximum value, the current-sensor determiner 301 proceeds to Step S211.

At Step S211, the current-sensor determiner 301 transmits a signal to a display (not depicted) to display a notice of non-normal connection, ending the process.

As in the foregoing, in the BMU 36 of the second embodiment, before the current-sensor drive voltage controller 1400 applies a drive voltage to the current sensor 34, causing a current to flow, the drive-voltage setter 1303 selects one of the voltages registered in the voltage-value list 101. Upon every voltage selection, the current-sensor drive voltage controller 1400 applies the selected drive voltage to all the current-sensor types registered in the current sensor information 100 to causes a current to flow therethrough and determine whether a normal output value can be received. Thus, according to the second embodiment, even if the drive voltage of each current-sensor type is unknown, the current-sensor determiner 301 can determine the type of the current sensor connected to the BMU 36, enabling more reliable current-sensor type determination.

Furthermore, according to the BMU 36 of the second embodiment, the drive-voltage setter 1303 selects drive voltages in order from the minimum value in the voltage-value list 101, making it possible to receive a normal output value from the current sensor 34 connected to the BMU 36 when applying the drive voltage of the connected current sensor 34. Thus, it is possible to prevent the current-sensor drive voltage controller 1400 from applying a voltage exceeding the drive voltage to the current sensor 34, causing a current to flow.

### Third Embodiment

In the first embodiment, before the current-sensor drive voltage controller 400 applies a drive voltage to the current sensor 34, causing a current to flow, the drive-voltage setter 303 selects the drive voltage from the current sensor information 100. In a third embodiment, a drive-voltage setter 2303 calculates a voltage value in increments and sets the calculated voltage value as the drive voltage.

The configuration of the storage battery system 10 and the configurations of the current sensor connectors 81 and 82 for connecting the BMU 36 and the current sensor 34 in the third embodiment are the same as those in the first embodiment described with reference to FIGS. 1 to 4.

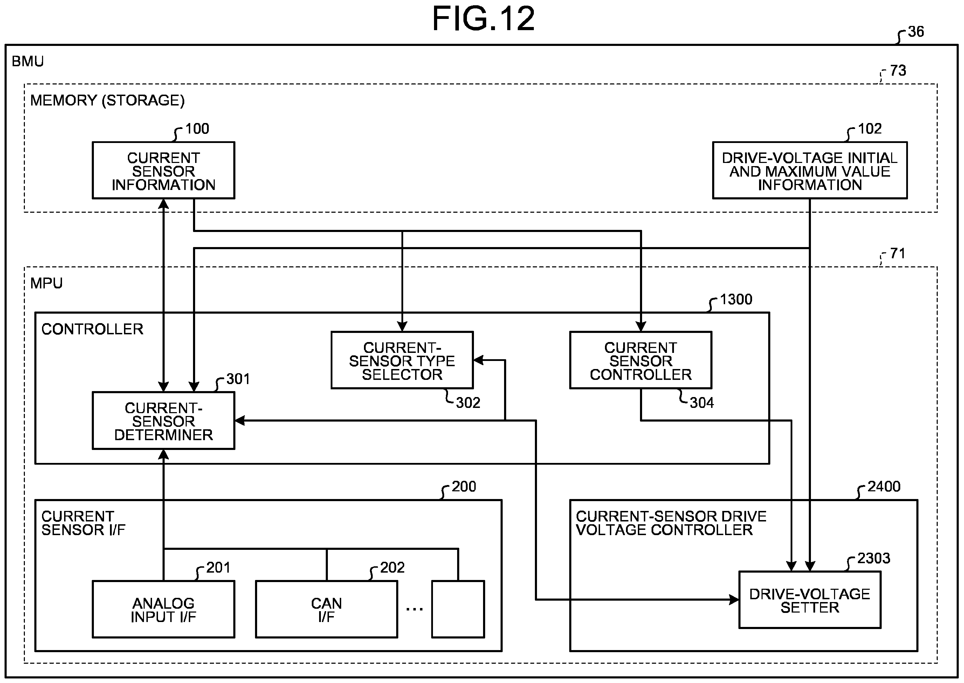

The functional configuration of the MPU 71 and the memory 73 inside the BMU 36 in the third embodiment will be described. FIG. 12 is a block diagram illustrating in detail one example of the functional configuration of the MPU 71 and the memory 73 inside the BMU 36 of the third embodiment.

The memory 73 of the third embodiment is a storage medium that stores drive-voltage initial and maximum value information 102 in addition to the current sensor information 100.

The current sensor information 100 of the third embodiment does not contain the drive-voltage information. The data in the rest of the items of the current sensor information 100 are similar to those in the first embodiment described with reference to FIG. 6.

A current-sensor drive voltage controller 2400 of the third embodiment includes a drive-voltage setter 2303. Thus, the controller 1300 includes no drive-voltage setter 303. The rest of the configuration of the BMU 36 is the same as that in the first embodiment.

The drive-voltage setter 2303 increases a voltage value by increments of, for example, 0.1 V, and sets the increased value as the drive voltage. However, limitless voltage increase will apply an excessive load on related devices. In order to prevent this, the process is ended when the value of the drive voltage reaches the maximum value registered in the drive-voltage initial and maximum value information 102.

Meanwhile, no current sensors 34 can be driven at too low voltage. Thus, in view of determination efficiency, the drive-voltage setter 2303 acquires an initial value from the drive-voltage initial and maximum value information 102.

The voltage value that the drive-voltage setter 2303 increases at one time may be pre-fixed and set to the drive-voltage setter 2303. However, it is not limited thereto. For example, the voltage value may be stored in the memory 73 or may be input from an external device (not depicted).

Each time the drive-voltage setter 2303 increases the drive voltage, the current-sensor drive voltage controller 2400 of the third embodiment applies an increased drive voltage to the current sensor 34, causing a current to flow through the current sensor 34.

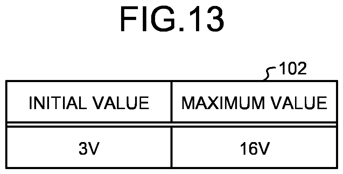

FIG. 13 is a diagram illustrating one example of the values of the drive-voltage initial and maximum value information 102 in the third embodiment. In FIG. 13, the initial value is set to 3 V, so that the drive voltage starts from 3 V, and the determination process ends when it reaches the maximum value of 16 V.

The values of the drive-voltage initial and maximum value information 102 illustrated in FIG. 13 are exemplary and are not limited thereto. Furthermore, with another means to stop the process when the voltage exceeds a certain value provided, setting the maximum value is omissible. If possible drive voltage values of the current sensor 34 connected to the BMU 36 are unknown, the initial value may be set to 0 V.

The location of storage of the drive-voltage initial and maximum value information 102 is not limited to the memory 73, and the information 102 may be fixed values and set to the current-sensor drive voltage controller 2400, for example.

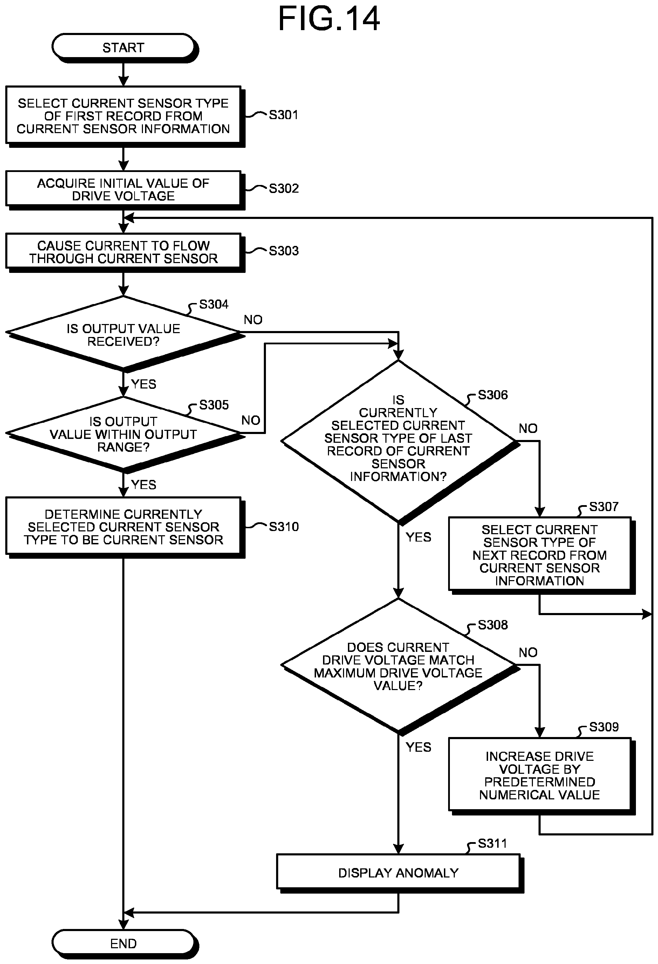

Next, the current-sensor type determination process performed by the above-configured BMU 36 of the third embodiment will be described. FIG. 14 is a flowchart illustrating a current-sensor type determination procedure of the third embodiment. As with the first embodiment, at start of the process of this flowchart, for example, the current-sensor determiner 301 detects no stored results of determination on the current-sensor type in the memory 73 upon initial activation of the BMU 36.

At Step S301, the current-sensor type selector 302 selects the current-sensor type of a first record from the current sensor information 100.

At next Step S302, the drive-voltage setter 2303 acquires an initial value from the drive-voltage initial and maximum value information 102.

At next Step S303, the current-sensor drive voltage controller 2400 applies the initial drive voltage value acquired by the drive-voltage setter 2303 to the current sensor 34 to cause a current to flow therethrough.

At Step S304, the current-sensor determiner 301 determines whether the current sensor I/F 200 has received an output value from the current sensor 34.

When determining receipt of the output value (Yes at S304), at Step S305 the current-sensor determiner 301 determines, referring to the current sensor information 100, whether the output value of the current sensor 34 received by the current sensor I/F 200 falls within the output range of the current-sensor type selected by the current-sensor type selector 302.

When the current sensor I/F 200 has received no output value from the current sensor 34 (No at S304) or when the received output value does not fall in the output range (No at S305), the current-sensor determiner 301 proceeds to the operation at Step S306.

At Step S306, the current-sensor determiner 301 determines, referring to the current sensor information 100, whether the current-sensor type currently selected by the current-sensor type selector 302 is of the last record in the current sensor information 100.

When the current-sensor type is not of the last record (No at S306), at Step S307 the current-sensor type selector 302 selects the current-sensor type of a next record from the current sensor information 100.

Returning to Step S303, the current-sensor drive voltage controller 2400 applies the same drive voltage as the previous one to the current sensor 34, causing a current to flow.

When the current sensor I/F 200 receives no output value from the current sensor 34 (No at S304) or when the received output value does not fall in the output range (No at S305), the current-sensor determiner 301 repeats the operation from Step S303 to Step S307 until the current-sensor type of the last record in the current sensor information 100 (No at S306).

When receiving no normal output value from all the current-sensor types registered in the current sensor information 100, the current-sensor determiner 301 proceeds to Step S308 after making the determination on the last record (Yes at S306).

At Step S308, the current-sensor determiner 301 determines whether the currently selected drive voltage by the drive-voltage setter 2303 has reached the maximum value, by comparing the drive voltage with the maximum value of the drive-voltage initial and maximum value information 102.

When the current drive voltage has not reached the maximum value (No at S308), at Step S309 the drive-voltage setter 2303 increases the drive voltage by a certain numerical value. The current-sensor type selector 302 selects the current-sensor type of the first record from the current sensor information 100.

Then, returning to Step S303, the current-sensor drive voltage controller 2400 applies to the current sensor 34 the increased drive voltage by the drive-voltage setter 2303 to cause a current to flow therethrough.

When the current sensor I/F 200 receives no output value from the current sensor 34 (No at S304) or when the received output value does not fall in the output range (No at S305), the current-sensor determiner 301 repeats the operation from Step S303 to Step S309 until the drive voltage value reaches the maximum value (No at S308).

Upon receipt of an output value in the output range from any of the current-sensor types (Yes at S305) before the drive voltage reaches the maximum value, the current-sensor determiner 301 proceeds to Step S310.

At Step S310, the current-sensor determiner 301 determines that the currently selected current-sensor type by the current-sensor type selector 302 is the current-sensor type of the current sensor 34 connected to the BMU 36, and registers the determined current-sensor type in the current sensor information 100, completing the determination process.

With every increase in the drive voltage, the operation from Step S303 and Step S309 is performed for all the current-sensor types. When receiving no output value within the output range (Yes at S308) with the maximum drive voltage value applied, the current-sensor determiner 301 proceeds to Step S311.

At Step S311, the current-sensor determiner 301 transmits a signal to a display (not depicted) to display a notice of non-normal connection, ending the process.

As in the foregoing, according to the BMU 36 of the third embodiment, the drive-voltage setter 2303 increases the drive voltage by a certain value and the current-sensor drive voltage controller 2400 applies the increased drive voltage, causing a current to flow through the current sensor 34, which makes it possible to control the drive voltage in smaller units. Consequently, according to the third embodiment, in determining the current-sensor type, the drive voltage of the current sensor 34 connected to the BMU 36 can be prevented from being omitted from the subject of setting. This enables more accurate current-sensor type determination. According to the third embodiment, it is also possible to prevent the current sensor 34 connected to the BMU 36 from being damaged due to a current flowing through the current sensor 34 with an applied voltage exceeding the drive voltage of the current sensor 34.

### Modification

In the first embodiment, the current-sensor determiner 301 determines each current-sensor type registered in the current sensor information 100 using only the drive voltage associated with the current-sensor type in question. However, the embodiment is not limited thereto. For example, in this modification, determination is made on whether output values from all the current-sensor types registered in the current sensor information 100 fall within the output ranges, using each drive voltage registered in the current sensor information 100.

The configuration of the storage battery system 10, the configurations of the current sensor connectors 81 and 82 for connecting the BMU 36 and the current sensor 34, and the functional configuration of the MPU 71 and the memory 73 in the BMU 36 according to the modification are the same as those in the first embodiment described with reference to FIGS. 1 to 5.

The current sensor information 100 according to the modification holds data similar to those in the first embodiment described with reference to FIG. 6.

The drive-voltage setter 303 according to the modification selects one of the drive voltages from the current sensor information 100 and refrains from selecting the drive voltage of a next record until the current-sensor determiner 301 makes the determination on the current-sensor types of all the records registered in the current sensor information 100 using the selected drive voltage.

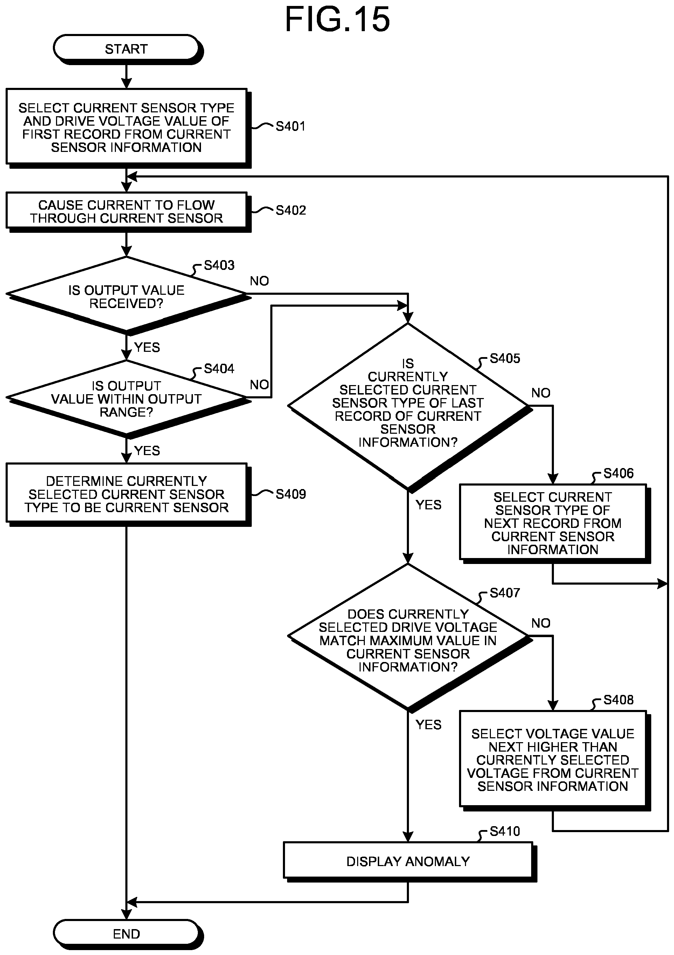

Next, the current-sensor type determination process performed by the above-configured BMU 36 according to the modification will be described. FIG. 15 is a flowchart illustrating a current-sensor type determination procedure according to the modification. As with the first embodiment, at start of the process of this flowchart, for example, the current-sensor determiner 301 detects no stored results of the current-sensor type determination in the memory 73, upon initial activation of the BMU 36.

At first Step S401, the current-sensor type selector 302 selects the current-sensor type of a first record from the current sensor information 100. The drive-voltage setter 303 selects the drive voltage of the first record from the current sensor information 100.

At next Step S402, the current-sensor drive voltage controller 400 applies the drive voltage selected by the drive-voltage setter 303 to the current sensor 34, causing a current to flow.

At Step S403, the current-sensor determiner 301 determines whether the current sensor I/F 200 has received an output value from the current sensor 34.

When determining receipt of the output value (Yes at S403), at Step S404 the current-sensor determiner 301 determines, referring to the current sensor information 100, whether the output value of the current sensor 34 received by the current sensor I/F 200 falls within the output range of the current-sensor type selected by the current-sensor type selector 302.

When the current sensor I/F 200 has received no output value from the current sensor 34 (No at S403) or when the received output value does not fall in the output range (No at S404), the current-sensor determiner 301 proceeds to the operation at Step S405.

At Step S405, the current-sensor determiner 301 determines, referring to the current sensor information 100, whether the current-sensor type currently selected by the current-sensor type selector 302 is of the last record in the current sensor information 100.

When the current-sensor type is not of the last record (No at S405), at Step S406 the current-sensor type selector 302 selects the current-sensor type of a next record from the current sensor information 100.

Then, returning to Step S402, the current-sensor drive voltage controller 400 applies to the current sensor 34 the same drive voltage as the previous one to cause a current to flow therethrough.

When the current sensor I/F 200 receives no output value from the current sensor 34 (No at S403) or when the received output value does not fall in the output range (No at S404), the current-sensor determiner 301 repeats the operation from Step S402 to Step S406 until the current-sensor type of the last record in the current sensor information 100 (No at S405).

When receiving no normal output value from all the current-sensor types registered in the current sensor information 100, the current-sensor determiner 301 proceeds to Step S407 after making the determination on the last record (Yes at S405).

At Step S407, the current-sensor determiner 301 determines whether the drive voltage currently selected by the drive-voltage setter 303 matches the maximum value in the current sensor information 100.

When the currently selected drive voltage does not match the maximum value in the current sensor information 100 (No at S407), at Step S408 the drive-voltage setter 303 selects a voltage value next higher than the currently selected voltage from the current sensor information 100 as the drive voltage. The current-sensor type selector 302 selects the current-sensor type of the first record from the current sensor information 100.

Then, returning to Step S402, the current-sensor drive voltage controller 400 applies the drive voltage selected by the drive-voltage setter 303 to the current sensor 34 to cause a current to flow therethrough.

When the current sensor I/F 200 receives no output value from the current sensor 34 (No at S403) or when the received output value does not fall in the output range (No at S404), the current-sensor determiner 301 repeats the operation from Step S402 to Step S408 until the maximum drive voltage value in the current sensor information 100 (No at S405).

Upon receipt of an output value within the output range (Yes at S404) with any of combinations of the drive voltages and the current-sensor types, at Step S409 the current-sensor determiner 301 determines that the current-sensor type currently selected by the current-sensor type selector 302 is the current-sensor type of the current sensor 34 connected to the BMU 36, and registers the determined current-sensor type in the current sensor information 100. This ends the determination process.

The operation from Step S402 to Step S408 is performed for all the current-sensor types using each drive voltage. Upon receipt of no output value within the output range using the maximum value in the current sensor information 100 (Yes at S407), the current-sensor determiner 301 proceeds to Step S410.

At Step S410, the current-sensor determiner 301 transmits a signal to the display (not depicted) to display a notice of non-normal connection, ending the process.

As in the foregoing, the BMU 36 according to the modification executes all the combinations of the current-sensor types and the drive voltages registered in the current sensor information 100, thereby preventing omission of determination on any of the current-sensor types .

In the above-described first to third embodiments and modification, in determining the current-sensor type, the BMU 36 varies the voltage in order from a small value to a large value and applies it to the current sensor 34. However, the order of the voltages to set is not limited thereto. In the case of applying a voltage exceeding the drive voltage of the current sensor 34, the BMU 36 sets a voltage-application time within the time for which all the current-sensor types registered in the current sensor information 100 can withstand the voltage in question, in order to prevent the current sensor 34 from being damaged.

As in the foregoing, the BMUs 36 of the first to the third embodiments and the modification can efficiently determine the current-sensor type, therefore, can control the current sensors 34 used in the storage battery system 10 with appropriate drive voltages in accordance with the types of the current sensors 34. Consequently, according to the first to the third embodiments and the modification, the same BMU 36 can be used in common for the current sensors 34 of different current-sensor types.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A storage battery management device comprising:
a connector connectable to a current sensor;
storage configured to store current sensor information including an output range and each current-sensor type in association with each other, the output range being a range of normal output values, the current-sensor type indicating a type of each current sensor connectable to the connector;
a drive voltage controller configured to cause a current to flow through the current sensor while varying a voltage to be applied to the current sensor;
a determiner configured to determine, based on whether an output value that is received via the connector from the current sensor driven by the current caused by the drive voltage controller falls in the output range corresponding to the current-sensor type; and
a current sensor controller configured to control the current sensor in accordance with the determined current-sensor type.

2. The storage battery management device according to claim 1, wherein
the current sensor information includes one or a plurality of drive voltages at which the current sensor is drivable, registered in association with each current-sensor type, and
the drive voltage controller causes a current to flow through the current sensor by applying to the current sensor the one or plurality of drive voltages registered in the current sensor information in order from a minimum value.

3. The storage battery management device according to claim 1, wherein the drive voltage controller causes a current to flow through the current sensor by applying to the current sensor one or a plurality of predetermined drive voltages in order from a minimum value.

4. The storage battery management device according to claim 1, wherein the drive voltage controller causes a current to flow through the current sensor by applying a drive voltage to the current sensor while increasing the drive voltage by a certain value.

5. The storage battery management device according to any one of claims 1 to 4, wherein
upon activation of the storage battery management device while no determination is made on the current-sensor type, the determiner determines the current-sensor type and stores the determined current-sensor type in the storage, and
the current sensor controller controls the current sensor in accordance with the current-sensor type stored in the storage.

6. The storage battery management device according to any one of claims 1 to 5, wherein the current-sensor type includes an analog and a controller area network (CAN).

7. A storage battery management method to be executed by a storage battery management device, the method comprising:
a drive-voltage controlling step of causing a current to flow through a current sensor while varying a voltage to be applied to the current sensor;
a step of receiving an output value from the current sensor;
a step of selecting one current-sensor type from current sensor information including an output range and each current-sensor type in association with each other, the output range being a range of normal output values, the current sensor type indicating a type of each current sensor connectable to the storage battery management device;
a step of determining whether an output value of the current sensor driven by the current caused by the drive-voltage controlling step falls in the output range corresponding to the selected current-sensor type, and, when the output value falls in the output range, determining that the selected current-sensor type is the current-sensor type connected to the storage battery management device; and
a current-sensor controlling step of controlling the current sensor in accordance with the determined current-sensor type.
